# DEMANDE DE BREVET EUROPEEN

(11) **EP 4 398 317 A1**
(43) Date de publication de la demande: **10.07.2024**
(21) Numéro de dépôt: 23218208.9
(22) Date de dépôt: 19.12.2023
(51) Int. Cl.: H01L 33/00, H01L 33/12, H01L 33/32, H01L 21/306, H01L 27/15, H01L 21/3063

(54) **PROCÉDÉ DE FABRICATION D'UN SUBSTRAT DE CROISSANCE COMPORTANT DES MÉSAS DE DIFFÉRENTES DÉFORMABILITÉS, PAR GRAVURE ET POROSIFICATION ÉLECTROCHIMIQUE**

(30) Priorité: 21.12.2022 FR 2214167
(71) Demandeur: Commissariat à l'Énergie Atomique et aux Énergies Alternatives, 75015 Paris (FR)
(72) Inventeur: ROL, Fabian, 38054 Grenoble cedex 09 (FR); DUSSAIGNE, Amélie, 38054 Grenoble cedex 09 (FR)
(74) Mandataire: Brevalex

(57) **Abrégé**

L'invention porte sur un procédé de fabrication d'un substrat de croissance adapté à la réalisation par épitaxie d'une matrice de diodes (D1, D2, D3) à base d'InGaN, comportant les étapes suivantes :
o réalisation d'un empilement cristallin (10) comportant, à partir d'une couche tampon conductrice (11) : une couche inférieure (12) à base de GaN dopé ; puis une couche intercalaire de séparation (13), à base d'InGaN ; puis une couche supérieure (14) à base d'AIGaN ;
o réalisation de mésas de trois catégories M1, M2, M3, par gravure localisée de l'empilement cristallin (10) ;
o suppression, par gravure, de la portion supérieure (24) d'au moins les mésas M3, la portion supérieure (24) des mésas M1 étant préservées ; puis
o porosification électrochimique non photo-assistée des portions inférieures (22) des seules mésas M1 et M3, la portion inférieure (22) des mésas M2 étant non porosifiée.

## Description

### DOMAINE TECHNIQUE

Le domaine de l'invention est celui des procédés de fabrication d'un substrat de croissance comportant des mésas, et permettant de réaliser une matrice de diodes adaptées à émettre ou à détecter, de manière native, un rayonnement lumineux à différentes longueurs d'onde.

### ÉTAT DE LA TECHNIQUE ANTÉRIEURE

Il existe des procédés de fabrication d'une matrice de diodes électroluminescentes adaptée à émettre, de manière native, un rayonnement lumineux à différentes longueurs d'onde. La matrice de diodes peut alors comporter des diodes adaptées à émettre une lumière rouge, d'autres diodes une lumière verte, et d'autres encore une lumière bleue. Une telle matrice de diodes forme alors un micro-écran à émission native RGB (pour *Red, Green, Blue,* en anglais).

Les diodes sont dites à émission native, dans le sens où la zone active de chaque diode émettant à une longueur d'onde donnée diffère des zones actives des diodes émettant à une autre longueur d'onde. Dans le cas des diodes réalisées à base d'InGaN, les zones actives diffèrent les unes des autres par la proportion d'indium dans les puits quantiques.

Une telle matrice de diodes à émission native se distingue ainsi des technologies à conversion de couleurs où les diodes émettent toutes à une même longueur d'onde, par exemple dans le bleu, et sont revêtues chacune d'un plot comportant des luminophores, par exemple des nanocristaux semiconducteurs formant des boîtes quantiques, pour convertir au moins en partie la lumière incidente en une lumière d'une autre longueur d'onde.

Pour fabriquer une matrice de diodes à émission native, une approche consiste à utiliser un substrat de croissance présentant des mésas ayant été en partie rendues poreuses lors d'une étape de porosification électrochimique. Cette technique de porosification électrochimique est présentée notamment dans l'article de Griffin et Oliver intitulé Porous nitride semiconductors reviewed, J. Phys. D: Appl. Phys. 53 (2020) 383002.

Le document EP3840065A1 décrit un exemple de procédé de fabrication d'un substrat de croissance puis d'une matrice de diodes utilisant la technique de porosification électrochimique. Le procédé comporte la réalisation d'un substrat de croissance (également appelé pseudo-substrat) présentant plusieurs mésas en InGaN, formées chacune d'une portion dopée en InGaN rendu poreux lors d'une étape de porosification électrochimique, et d'une portion de reprise d'épitaxie en InGaN non intentionnellement dopé ou faiblement dopé de sorte qu'il n'est pas porosifié (il reste intègre ou dense, donc non poreux). Les diodes sont ensuite réalisées par épitaxie à partir des portions de reprise d'épitaxie.

Les portions dopées des mésas peuvent présenter des niveaux de dopage différents d'une mésa à l'autre, de sorte que les mésas présentent des niveaux de porosification différents et donc des taux de relaxation différents. Les diodes réalisées à partir des différentes mésas comportent alors des puits quantiques ayant une proportion d'indium plus ou moins importante, permettant ainsi d'obtenir des pixels émissifs à différentes longueurs d'onde.

Cependant, pour obtenir des mésas dont les couches dopées en InGaN présentent différents niveaux de dopage d'une mésa à l'autre, il est nécessaire d'effectuer, avant l'étape de réalisation des mésas, une étape d'implantation spatialement localisée de dopants dans une couche d'InGaN pleine plaque, ce qui complexifie le procédé de fabrication.

### EXPOSÉ DE L'INVENTION

L'invention a pour objectif de remédier au moins en partie aux inconvénients de l'art antérieur, et plus particulièrement de proposer un procédé de fabrication d'un substrat de croissance, adapté à la réalisation d'une matrice de diodes à base d'InGaN, et comportant des mésas de déformabilités différentes, sans qu'il ait été nécessaire de réaliser des implantations spatialement localisées de dopants. Ces mésas de différentes déformabilités permettent ainsi de réaliser de manière native des diodes à base d'InGaN pouvant chacune émettre ou détecter un rayonnement lumineux à différentes longueurs d'onde, par exemple dans les trois couleurs RGB.

Pour cela, l'objet de l'invention est un procédé de fabrication d'un substrat de croissance adapté à la réalisation par épitaxie d'une matrice de diodes à base d'InGaN, comportant les étapes suivantes :
- réalisation d'un empilement cristallin à base de GaN, comportant, à partir d'une couche tampon conductrice réalisée à base de GaN dopé : une couche inférieure à base de GaN dopé ; puis une couche intercalaire de séparation, à base d'InGaN ; puis une couche supérieure à base d'AIGaN ;
- réalisation de mésas de trois catégories M1, M2, M3, par gravure localisée de l'empilement cristallin, chaque mésa étant alors formée d'un empilement d'une portion inférieure, d'une portion intercalaire de séparation, et d'une portion supérieure, issues respectivement de la couche inférieure, de la couche intercalaire de séparation et de la couche supérieure ;
- suppression, par gravure, de la portion supérieure d'au moins les mésas M3, la portion supérieure des mésas M1 étant préservées ; puis
- porosification électrochimique non photo-assistée des portions inférieures des seules mésas M1 et M3, la portion inférieure des mésas M2 étant non porosifiée.

Certains aspects préférés mais non limitatifs de ce procédé de fabrication sont les suivants.

L'étape de suppression peut être réalisée par gravure photoélectrochimique de la portion intercalaire de séparation d'au moins les mésas M3, les mésas M 1 étant recouvertes par une couche d'encapsulation.

L'étape de suppression peut être réalisée par gravure sèche de la portion supérieure d'au moins les mésas M3, avec arrêt de gravure sur la portion intercalaire de séparation, les mésas M1 étant recouvertes par un masque de gravure.

A la suite de l'étape de réalisation des mésas, la portion intercalaire de séparation peut être, dans chaque mésa, sur et au contact de la portion inférieure, le procédé comportant alors une étape de réalisation de portions de reprise d'épitaxie réalisée à base d'InGaN, effectuée après l'étape de porosification électrochimique, reposant sur la portion supérieure dans les mésas M1, et reposant sur la portion inférieure dans les mésas M3.

Le procédé peut comporter, à la suite des étapes de suppression et de porosification et avant l'étape de réalisation de la portion de reprise d'épitaxie, une étape de réalisation d'une portion d'obturation déposée au moins sur et au contact de la portion inférieure des mesas M3 alors porosifiée.

Lors de l'étape de réalisation de l'empilement cristallin, une couche de reprise d'épitaxie peut être située sur et au contact de la couche inférieure, de sorte que, à la suite des étapes de suppression et de porosification, les mésas M3 présentent une face supérieure formée par une portion de reprise d'épitaxie issue de la couche de reprise d'épitaxie.

L'invention porte également sur un procédé de fabrication d'une matrice de diodes de catégories D1, D2, D3 à partir d'un substrat de croissance, comportant les étapes suivantes : fabrication du substrat de croissance par le procédé selon l'une quelconque des caractéristiques précédentes ; puis dépôt d'un masque de croissance, laissant libre une surface supérieure des mésas M1, M2, M3 ; puis réalisation de la matrice de diodes D1, D2, D3, respectivement à partir des mésas M1, M2, M3.

L'invention porte également sur un substrat de croissance adapté à la réalisation par épitaxie d'une matrice de diodes à base d'InGaN, comportant :
- une couche tampon conductrice, réalisée à base de GaN dopé ;
- des mésas de trois catégories M1, M2, M3, reposant sur la couche tampon conductrice, comportant chacune une portion inférieure réalisée à base de GaN dopé, et
   ∘ les mésas M1 comportant en outre une portion intercalaire de séparation non poreuse et réalisée à base d'InGaN, reposant sur la portion inférieure poreuse ; puis une portion supérieure non poreuse et réalisée à base d'AIGaN ;
   ∘ les mésas M2 étant formés de la portion inférieure non poreuse ;
   ∘ les mésas M3 étant formés de la portion inférieure poreuse, et ne comportant pas de portion supérieure non poreuse réalisée à base d'AIGaN reposant sur la portion inférieure.

Chaque mésa M1, M2, M3 peut comporter une portion de reprise d'épitaxie non poreuse réalisée à base d'InGaN dopé, reposant, dans les mésas M1, sur la portion supérieure, et, dans les mésas M3, sur la portion inférieure.

Chaque mésa M1, M2, M3 peut comporter une portion d'obturation non poreuse réalisée à base de GaN, située, dans les mésas M1, entre et au contact de la portion supérieure et de la portion de reprise d'épitaxie, et dans les mésas M3, entre et au contact de la portion inférieure et de la portion de reprise d'épitaxie.

Chaque mésa M1, M2, M3 peut comporter une portion intercalaire de reprise d'épitaxie réalisée à base d'InGaN et située, dans les mésas M1, entre la portion inférieure et la portion intercalaire de séparation, dans les mésas M3, sur la portion inférieure.

La portion intercalaire de reprise d'épitaxie de chaque mésa M1, M2, M3 peut être non poreuse.

La portion intercalaire de reprise d'épitaxie peut être poreuse dans les mésas M1, et non poreuse dans les mésas M2 et M3.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A à 1H illustrent des étapes d'un procédé de fabrication d'un substrat de croissance, puis d'une matrice de diodes, selon un premier mode de réalisation où l'étape de suppression des portions supérieures à base d'AlGaN est effectué par gravure photoélectrochimique ;
Les figures 2A à 2D illustrent des étapes d'un procédé de fabrication d'un substrat de croissance, puis d'une matrice de diodes, selon une variante du premier mode de réalisation, où l'empilement cristallin comporte une couche intercalaire de reprise d'épitaxie de faible épaisseur et destinée à ne pas être porosifiée ;
les figures 3A à 3E illustrent des étapes d'un procédé de fabrication d'un substrat de croissance, puis d'une matrice de diodes, selon une autre variante du premier mode de réalisation, où l'empilement cristallin comporte une couche intercalaire de reprise d'épitaxie destinée à être porosifiée, et pouvant présenter une épaisseur plus importante que dans le cas des fig.2A-2D ;
les figures 4A à 4F illustrent des étapes d'un procédé de fabrication d'un substrat de croissance, puis d'une matrice de diodes, selon un deuxième mode de réalisation où l'étape de suppression des portions supérieures à base d'AlGaN est effectué par gravure sèche.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un substrat de croissance et son procédé de fabrication. Le substrat de croissance est adapté à la réalisation par épitaxie d'une matrice de diodes à base d'InGaN, les diodes permettant d'émettre ou de détecter, de manière native, un rayonnement lumineux à différentes longueurs d'onde, par exemple de type RGB (rouge, vert, bleu).

Le substrat de croissance comporte des mésas d'au moins trois catégories différentes, notées M1, M2 et M3, ayant différentes déformabilités d1, d2, d3, selon que les mésas comportent ou non une portion supérieure à base d'AIGaN, et selon qu'elles comportent une portion inférieure à base de GaN et/ou une portion de reprise d'épitaxie à base d'InGaN porosifiées ou non. D'une manière générale, la déformabilité est la capacité de la mésa à se déformer lors de la réalisation de la diode.

Les différentes déformabilités d1, d2, d3 des mésas se traduisent par le fait que les mésas M1, M2, M3 présentent alors différentes valeurs du paramètre de maille effectif, d'une catégorie de mésas à l'autre, au niveau de leur face supérieure, lors de la croissance des diodes. Le paramètre de maille effectif est le paramètre de maille, défini dans un plan principal XY (orthogonal à l'axe de croissance des couches), de la couche ou portion de couche considérée. Aussi, les diodes de catégories D1, D2 et D3, réalisées lors d'une même étape d'épitaxie à partir du substrat de croissance, présenteront des zones actives différentes en termes de proportion d'indium incorporé dans les puits quantiques, et seront donc adaptées à émettre ou détecter un rayonnement lumineux à différentes longueurs d'onde.

Le procédé de fabrication propose de réaliser tout d'abord des mésas M1, M2, M3 à base de GaN, comportant chacune une portion inférieure à base de GaN, une portion intercalaire dite de séparation à base d'InGaN, et une portion supérieure à base d'AlGaN. Puis, la portion supérieure à base d'AIGaN d'au moins les mésas M3, et éventuellement des mésas M2 également, sont supprimées par gravure, alors qu'elles sont conservées dans les mésas M1. Cette étape de suppression peut être, dans un premier mode de réalisation, effectuée par gravure photoélectrochimique de la portion intercalaire de séparation à base d'InGaN, ou, dans un deuxième mode de réalisation, effectuée par gravure sèche des portions supérieures à base d'AlGaN avec arrêt de gravure sur les portions intercalaires de séparation à base d'InGaN. Le procédé prévoit également de porosifier par porosification électrochimique les portions inférieures des seules mésas M1 et M3, alors qu'elles ne sont pas porosifiées dans les mésas M2.

Rappelons que la gravure photoélectrochimique est effectuée en plongeant le substrat de croissance dans un électrolyte liquide, et en éclairant les mésas par un faisceau lumineux d'excitation apte à être absorbé par les seules portions intercalaires de séparation. Le matériau de ces portions intercalaires est alors oxydé et dissous par l'électrolyte liquide. Une faible tension électrique V_{PECE} peut être appliquée pour collecter les électrons photogénérés. Par ailleurs, rappelons également que la porosification électrochimique (porosification par anodisation électrochimique) est effectuée en plongeant également le substrat de croissance dans un électrolyte liquide. Une tension électrique d'une valeur V_{ECE} plus élevée est appliquée, provoquant la porosification des portions de couches voulues. Dans le cadre de l'invention, la porosification électrochimique est non-photo-assistée.

Rappelons ici qu'une réaction de porosification électrochimique est une réaction sélective dans le sens où, pour une même tension électrique de valeur V_{ECE}, un matériau semiconducteur cristallin à base de GaN sera porosifié si son niveau de dopage N_{D} est supérieur ou égal à un niveau de dopage minimal N_{D,min}(V_{ECE}) prédéfini. Dans le cas contraire, il ne sera pas porosifié et restera intègre (dense). A ce titre, le document EP3840016A1 illustre un exemple du domaine d'existence de la porosification électrochimique en fonction du niveau de dopage N_{D} (ici en donneurs) du matériau cristallin à base de GaN et de la tension électrique V_{ECE} appliquée.

On obtient ainsi un substrat de croissance, où :
∘ les mésas M2 présentent une déformabilité d2 minimale, dans la mesure où ils ne comportent pas de portions porosifiées. Le paramètre de maille effectif a_{M2} est celui d'une couche tampon conductrice à base de GaN sur laquelle les mésas reposent (moyennant une légère relaxation liée à la réalisation des mésas). De préférence, on aura donc : a_{M2} ≈ a_{GaN} ;
o les mésas M1 présentent une déformabilité d1 supérieure à d2, dans la mesure où elles comportent une portion inférieure à base de GaN porosifiée et une portion supérieure à base d'AlGaN non porosifié. Celle-ci contraint alors les mésas M1 en compression, et conduit à un paramètre de maille effectif a_{M1}, lors de la réalisation des diodes, inférieur à celui des mésas M2 : a_{M1} < a_{M2};
o les mésas M3 présentent également une déformabilité d3 supérieure à d2, dans la mesure où elles comportent une portion inférieure à base de GaN porosifiée. Les mésas M3 comportent également une portion de reprise d'épitaxie à base d'InGaN non porosifié, qui contraint alors les mésas M3 en tension, et conduit à un paramètre de maille effectif a_{M1}, lors de la réalisation des diodes, supérieur à celui des mésas M2 : a_{M3} > a_{M2}.

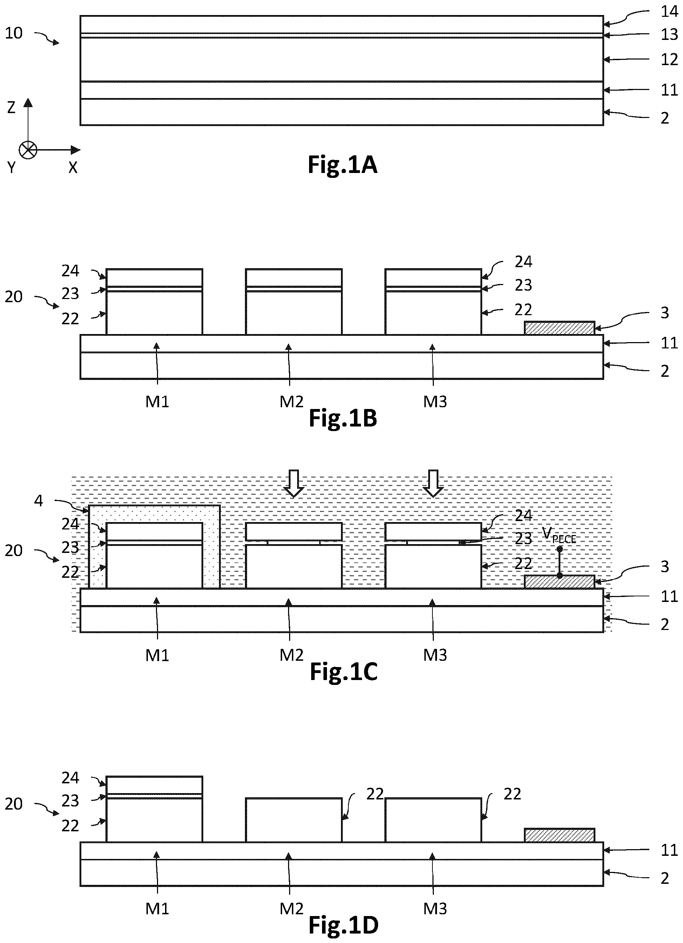

Les figures 1A à 1H illustrent des étapes d'un procédé de fabrication d'un substrat de croissance 20, puis d'une matrice de diodes, selon un premier mode de réalisation où l'étape de séparation des portions supérieures 24 à base d'AlGaN est effectuée par gravure photoélectrochimique. La matrice de diodes forme, dans cet exemple, un micro-écran à émission native RGB.

On définit ici et pour la suite de la description un repère direct tridimensionnel orthogonal XYZ, où les axes X et Y forment un plan principal du substrat support 2 et où l'axe Z est orienté suivant l'épaisseur du substrat de croissance 20 en direction des mésas.

En référence à la fig.1A, on réalise un empilement cristallin 10 à base de GaN reposant sur un substrat support 2. D'une manière générale, par « matériau à base de GaN », on entend que le matériau peut être du GaN ou peut être un composé ternaire ou quaternaire du GaN. Il peut ainsi être, d'une manière générale, de l'InₓAl_{y}Ga_{1-x-y}N où la proportion d'indium x peut être nulle et où la proportion d'aluminium y peut également être nulle. En revanche, « par matériau à base d'InGaN », on entend qu'il est en InGaN ou en InAIGaN, c'est-à-dire qu'il peut être réalisé en l'InₓAl_{y}Ga_{1-x-y}N où la proportion d'indium x est non nulle et où la proportion d'aluminium y peut être nulle. De même, « par matériau à base d'AIGaN », on entend qu'il est en AlGaN ou en InAIGaN, c'est-à-dire qu'il peut être réalisé en l'InₓAl_{y}Ga_{1-x-y}N où la proportion d'indium x peut être nulle et où la proportion d'aluminium y est non nulle.

Le substrat support 2 est réalisé ici en un matériau non porosifiable, de sorte qu'il reste non poreux (dense) lors de la porosification ultérieure des mésas M1 et M3. Il peut s'agir d'un matériau inerte à la réaction électrochimique de porosification, tel qu'un matériau isolant (saphir...) ou un matériau semiconducteur (SiC, Si...) non intentionnellement dopé (nid) ou faiblement dopé. Il peut également s'agir d'un matériau semiconducteur à base de GaN non intentionnellement dopé ou faiblement dopé pour ne pas être porosifiable à la tension de porosification V_{ECE}. A titre d'exemple, la couche support peut être réalisée en saphir, en silicium, en SiC, en GaN autoportant (freestanding en anglais), entre autres. Elle présente une épaisseur par exemple comprise entre 200µm et 1.2mm environ. Des couches intermédiaires peuvent être présentes entre le substrat support 2 et la couche tampon conductrice 11, réalisées par exemple à base d'AIN. Ainsi, à titre d'exemples, on peut utiliser les empilements suivants : Si/AIN/AIGaN/GaN ; saphir/GaN nid ; SiC/AIN/AIGaN etc... Le substrat support 2 peut être absent si la couche tampon conductrice 11 présente une épaisseur suffisante pour assurer la tenue mécanique du substrat de croissance 20.

L'empilement cristallin 10 comporte une couche tampon conductrice 11, sur laquelle reposeront les mésas M1, M2, M3 et qui permettra d'appliquer un potentiel électrique aux portions inférieures 22 des mésas à partir d'une électrode de polarisation 3. Pour cela, la couche tampon conductrice 11 est réalisée en un matériau cristallin à base de GaN dopé (ici de type n) sur au moins une partie de son épaisseur, avec par exemple un niveau de dopage de 10¹⁸ cm⁻³. La couche tampon conductrice 11 est réalisée par épitaxie à partir du substrat support 2. Elle peut présenter une épaisseur comprise entre 1 et 10µm environ. Avec ce niveau de dopage, la couche tampon conductrice 11 n'est pas porosifiée lors de l'étape ultérieure de porosification électronique (à la tension électrique de l'ordre de 15V environ), et permet la circulation des porteurs de charge.

La couche inférieure 12 repose sur la couche tampon conductrice 11 et est en contact électrique avec elle (et ici en contact physique). Elle est destinée à former les portions inférieures 22 des mésas, dont seules les portions inférieures 22 des mésas M1 et M3 seront porosifiées. Elle est réalisée à base de GaN, et peut, d'une manière générale, être réalisée en InₓGa₁₋ₓN avec une proportion d'indium x, positive ou nulle, inférieure à celle de la couche intercalaire de séparation 13 pour ne pas absorber le faisceau lumineux d'excitation lors de l'étape ultérieure de gravure photoélectrochimique. Elle est dopée suffisamment pour que les portions inférieures 22 des mésas M1 et M3 soient porosifiées lors de l'étape ultérieure de porosification électrochimique. Dans cet exemple, elle est réalisée en GaN dopé de type n avec un niveau de dopage de 6×10¹⁸ cm⁻³ environ. Son épaisseur est de l'ordre de plusieurs centaines de nanomètres pour permettre une bonne relaxation des contraintes mécaniques des mésas M1 et M3, par exemple au moins égale à 500nm, et est ici égale à 1000nm environ.

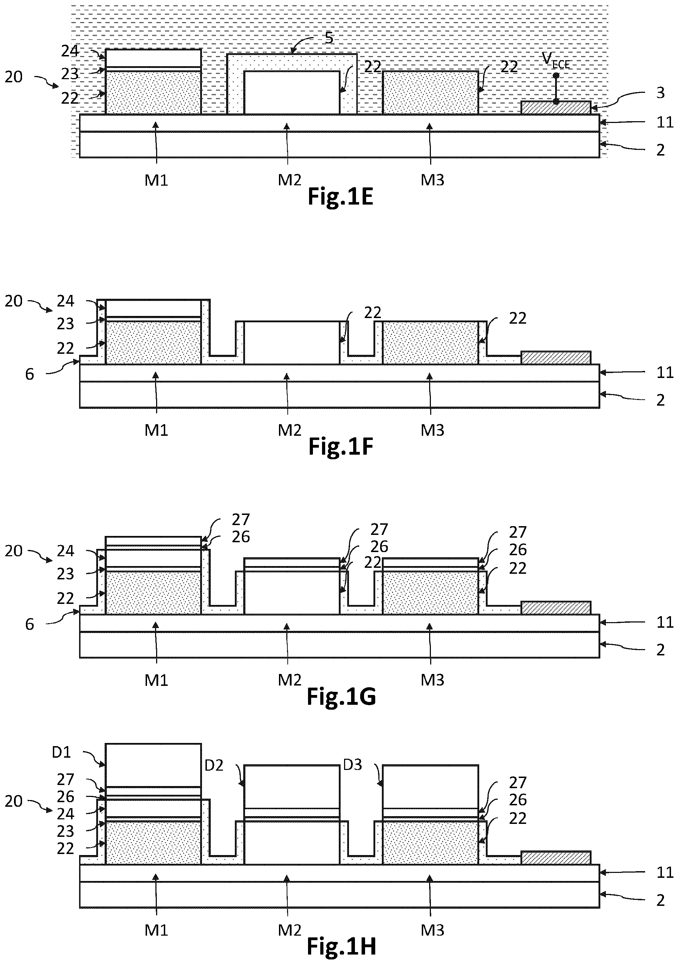

La couche intercalaire de séparation 13 repose sur la couche inférieure 12, et est ici en contact avec elle. Elle est destinée à être gravée, lors de l'étape ultérieure de gravure photoélectrochimique, pour assurer le retrait des portions supérieures 24 des seules mésas M2 et M3 (et non pas des mésas M1). Il s'agit donc d'une couche sacrificielle. Elle est réalisée à base d'InₓGa₁₋ₓN, avec une proportion d'indium x non nulle supérieure à celles des couches inférieure 12 et supérieure 14, par exemple comprise entre 10 et 15%, pour être la seule à absorber le faisceau lumineux d'excitation lors de l'étape ultérieure de gravure photoélectrochimique. Autrement dit, son énergie de bande interdite est inférieure à celle des couches inférieure 12 et supérieure 14. Dans cet exemple, elle est réalisée en InGaN non intentionnellement dopé, avec une proportion d'indium x de 15% environ. Son épaisseur est de l'ordre de quelques nanomètres, par exemple de 3nm environ. Elle peut ainsi former un unique puits quantique ou plusieurs puits quantiques. Notons que l'InGaN se porosifie à une tension électrique V_{ECE} plus faible que celle du GaN, à niveau de dopage équivalent. La proportion d'indium x et le niveau de dopage sont choisis ici pour que la portion intercalaire de séparation 23 ne soit pas porosifiée lors de l'étape de porosification de la fig.1E.

La couche supérieure 14 repose sur la couche intercalaire de séparation 13, et est ici en contact avec elle. Elle est destinée à former les portions supérieures 24 des mésas, dont celle des mésas M3 sera supprimée (et ici également celle des mésas M2) lors de l'étape ultérieure de gravure photoélectrochimique, et celle des mésas M1 sera conservée. Elle est réalisée à base d'Al_{y}Ga_{1-y}N, avec une proportion d'aluminium y non nulle, supérieure à celles des couches inférieure 12 et intercalaire 13. Le niveau de dopage est choisi pour que la portion supérieure 24 des mésas M1 ne soit pas porosifiée lors de l'étape ultérieure de porosification électrochimique. Le matériau peut donc être non intentionnellement dopé ou faiblement dopé. Dans cet exemple, elle est réalisée en AlGaN non intentionnellement dopé avec une proportion d'aluminium y de 10% environ. Son épaisseur est de l'ordre de la centaine de nanomètres, par exemple de 100nm environ. Notons que la couche supérieure 14 peut être recouverte d'une fine couche de protection (non représentée), par exemple en GaN ou en InGaN d'une épaisseur de l'ordre de 1 à 3nm, pour éviter l'oxydation de l'AIGaN.

Notons ici que les couches inférieure 12, intercalaire 13 et supérieure 14 présentent chacune une épaisseur inférieure à leur épaisseur critique à laquelle il y a une relaxation plastique des contraintes mécaniques. L'épaisseur totale de l'empilement cristallin 10 est également inférieure à une épaisseur critique prédéfinie. Ainsi, la couche tampon conductrice 11 génère, dans les couches inférieure 12, intercalaire 13 et supérieure 14, des contraintes mécaniques (orientées dans le plan XY) dont la valeur est telle que, avant porosification, le paramètre de maille effectif est proche ou sensiblement égal au paramètre de maille effectif de la couche tampon conductrice 11, ici sensiblement égal à celui du GaN relaxé (ou légèrement en compression s'il est réalisé à partir du saphir).

En référence à la fig.1B, on réalise les mésas M1, M2 et M3 par structuration de l'empilement cristallin 10 par lithographie et gravure localisée. La gravure est effectuée ici jusqu'à déboucher sur la face supérieure de la couche tampon conductrice 11. La gravure peut être une gravure sèche, par exemple de type plasma ICP-RIE au gaz chloré, de sorte que les flancs des mésas sont sensiblement verticaux. Chaque mésa est formée d'un empilement, suivant la direction +Z, d'une portion inférieure 22 à base de GaN (issue de la couche inférieure 12), d'une portion intercalaire de séparation 23 à base d'InGaN (issue de la couche intercalaire 13), et d'une portion supérieure 24 à base d'AIGaN (issue de la couche supérieure 14). Dans la mesure où les mésas sont réalisées à partir du même empilement cristallin 10, chaque portion d'une mésa est coplanaire avec les portions correspondantes des autres mésas et présente la même épaisseur.

On dépose ensuite une électrode de polarisation 3 sur et au contact de la couche tampon conductrice 11, qui permettra d'appliquer un potentiel électrique aux mésas.

En référence à la fig.1C, on supprime les portions supérieures 24 d'au moins les mésas M3 (et ici également des mésas M2), et non pas des mésas M1. Dans ce mode de réalisation, cette suppression est obtenue par la gravure électrochimique photo-assistée de toute la portion intercalaire 23 des mésas M2 et M3. En revanche, les mésas M1 sont protégées par une couche d'encapsulation 4 empêchant la gravure de la portion intercalaire 23 des mésas M1.

Pour cela, on dépose tout d'abord la couche d'encapsulation 4 sur les mésas M1, de manière à les recouvrir entièrement. Les mésas M2 et M3 ne sont pas recouverte pas cette couche 4. Ce peut être une résine photosensible, voir une couche conforme d'un oxyde. La portion intercalaire 23 des mésas M1 ne sera donc pas en contact avec l'électrolyte liquide.

Ensuite, on effectue la gravure des portions intercalaires 23 des mésas M2 et M3. On plonge le substrat de croissance 20 dans un électrolyte liquide permettant de dissoudre l'InGaN oxydé formé par l'absorption du faisceau lumineux d'excitation. L'électrolyte liquide peut être acide ou basique, et peut être de l'acide oxalique. Il peut également s'agir de KOH, HF, HNO₃, NaNO₃, H₂SO₄ ou de leur mélange. On peut ainsi utiliser également un mélange d'acide oxalique et de NaNO₃. On soumet également le substrat de croissance 20 à un faisceau lumineux d'excitation dont le spectre permet de n'exciter que la portion intercalaire 23. Il peut s'agir d'une lampe de lumière blanche associée à un filtre, d'une LED, voire d'une source laser. Ainsi, un laser à 405nm peut être utilisé pour n'exciter que les portions intercalaires 23 en InGaN à 15% d'indium. Par ailleurs, une tension électrique V_{PECE} peut être appliquée par un générateur électrique entre l'électrode de polarisation et une contre-électrode insérée dans l'électrolyte (par exemple, un fil ou une grille de platine). Elle peut être égale par exemple à 2V. Cette tension électrique V_{PECE} permet d'améliorer la collection des électrons photogénérés.

En référence à la fig.1D, à la suite de l'étape de suppression par gravure photoélectrochimique, on retire la couche d'encapsulation 4. Les mésas M2 et M3 ont donc perdu leur portion supérieure 24, du fait de la gravure totale des portions intercalaires 23. La face supérieure correspond donc à celle des portions inférieures 22. En revanche, la face supérieure des mésas M1 correspond toujours à la portion supérieure 24 (ou à la portion fine de protection).

En référence à la fig.1E, on effectue une porosification électrochimique, non photo-assistée, des portions inférieures 22 des seules mésas M1 et M3, et non pas de celle des mésas M2. Pour cela, on dépose une couche d'encapsulation 5 sur les seules mésas M2, par exemple une résine photosensible ou une couche d'oxyde ou de nitrure de silicium (dépôt conforme). Ainsi, les mésas M2 ne seront pas au contact de l'électrolyte liquide. En revanche, les mésas M1 et M3 ne sont pas recouvertes par cette couche d'encapsulation 5.

Ensuite, on plonge à nouveau le substrat de croissance 20 dans un électrolyte liquide. L'électrode de polarisation 3 est alors connectée au générateur électrique de manière à appliquer une tension électrique de valeur V_{ECE}, par exemple ici égale à 15V. Cela se traduit par une porosification des portions inférieures 22 des mésas M1 et M3, qui seules sont au contact de l'électrolyte liquide. La portion inférieure 22 de la mésa M2n'est donc pas porosifiée. La tension électrique peut être appliquée pendant une durée allant de quelques secondes à quelques heures. Une électrode de référence peut être utilisée pour contrôler précisément la tension électrique appliquée. Au cours de cette étape, il n'y a pas d'émission du faisceau lumineux d'excitation en direction des mésas. On retire ensuite le substrat de croissance 20 du bain électrolytique, et on retire la couche d'encapsulation 5.

Ainsi, on obtient un substrat de croissance 20, dont les mésas, qui présentent différentes déformabilités, ont été obtenues à partir d'un même empilement cristallin 10 initial. Il est donc adapté à la réalisation par épitaxie d'une matrice de diodes permettant d'émettre ou de recevoir un rayonnement lumineux à différentes longueurs d'onde de manière native, en particulier après avoir réalisé des portions de reprise d'épitaxie 27 à base d'InGaN.

Ainsi, les mésas M2 présentent une déformabilité d2 minimale, par le fait qu'elle n'est pas porosifiée. Dans cet exemple, elle ne comporte plus la portion supérieure 24 à base d'AlGaN. En variante, comme indiqué précédemment, elle pourrait l'avoir gardée, auquel cas la portion supérieure 24 serait non porosifiée (comme la portion inférieure 22). Quoi qu'il en soit, les mésas M2 présentent un paramètre de maille effectif qui est sensiblement égal à celui de la couche tampon conductrice 11, voire est sensiblement égal au paramètre de maille du matériau relaxé de la couche 11, du fait de la faible relaxation des mésas lors de leur réalisation (fig.1B). Elles permettront la réalisation de diodes D2 émettant par exemple dans le vert.

Les mésas M1 présentent une déformabilité d1 supérieure à d2 du fait de la porosification de la portion inférieure 22. De plus, la portion inférieure 22 porosifiée permet aux mésas M1 de relaxer sous l'effet des contraintes mécaniques en compression générées par la portion supérieure 24 à base d'AlGaN non porosifié, de sorte que le paramètre de maille effectif est alors inférieur à celui des mésas M2. Cependant, après cette relaxation, la portion 24 va limiter la déformation de la mésa M1 lors de la réalisation des diodes, et donc limiter l'incorporation d'indium. Les mésas M1 permettront la réalisation de diodes D1 émettant par exemple dans le bleu.

Enfin, les mésas M3 présentent une déformabilité d3 supérieure à d2 et différente de d1, du fait de la porosification de la portion inférieure 22 et à l'absence de la portion supérieure 24 à base d'AlGaN. Les mésas M3 pourront présenter, lors de la réalisation de la portion de reprise d'épitaxie 27 à base d'InGaN, un paramètre de maille effectif supérieur à celui des mésas M2 du fait des contraintes mécaniques en tension générées par la portion 27. Les mésas M3 permettront la réalisation de diodes D3 émettant par exemple dans le rouge.

En référence à la fig.1F, on réalise ensuite la matrice de diodes par reprise d'épitaxie à partir des mésas du substrat de croissance 20. On dépose tout d'abord un masque de croissance 6, réalisé en un matériau diélectrique, ici de manière conforme (par exemple par PECVD), de manière à recouvrir les flancs des mésas ainsi que la couche tampon conductrice 11. Le masque de croissance 6 peut être réalisé, par exemple, en un nitrure de silicium ou en un bicouche d'un nitrure et d'un oxyde de silicium d'une épaisseur de 80nm environ. Seule une surface des faces supérieures des mésas M1, M2, M3 est laissée libre par le masque de croissance 6, de manière à former une surface de germination. Ensuite, un recuit sous ammoniac et à haute température (par ex, entre 750 et 900°C) peut être effectué pour nettoyer les surfaces supérieures des mésas M1, M2, M3.

En référence à la fig.1G, on dépose par épitaxie une fine couche 26 à base de GaN sur les surfaces supérieures des mésas, et en particulier sur celle des mésas M3, de manière à obturer les pores de la portion inférieure 22 porosifiée qui débouchent sur la surface supérieure. A titre d'exemple, cette couche d'obturation 26 peut être réalisée en InGaN avec une proportion d'indium de 1% environ et d'une épaisseur comprise entre 10 et 100nm environ.

Ensuite, on réalise des portions de reprise d'épitaxie 27 sur les mésas M1, M2 et M3 et en particulier sur celle des mésas M3. Ces portions 27 peuvent présenter une épaisseur de 200nm environ et peuvent être réalisées en InGaN avec une proportion d'indium de l'ordre de 8% environ. La portion de reprise d'épitaxie 27 provoque alors la déformation de la portion inférieure 22 porosifiée des mésas M3 (contraintes en tension), qui en retour permettent aux portions de reprise d'épitaxie 27 de relaxer. De plus, le paramètre de maille au niveau de la face supérieure des mésas M3 est différent de celui des mésas M1.

En référence à la fig.1H, on réalise les diodes D1, D2, D3 à partir du substrat de croissance 20, de manière simultanée, par reprise d'épitaxie à partir des mésas M1, M2, M3. Ainsi, on dépose, sur chaque mésa, lors d'une même étape de dépôt par épitaxie, une première portion à base d'InGaN dopé de type n, qui sera alors plus ou moins relaxé en fonction des catégories M1, M2, M3 de mésas. Ainsi, une épaisseur de 200nm d'une première portion d'InGaN avec 8.5% d'indium permet d'obtenir un paramètre de maille effectif de 3.208Â sur les mésas M3. Lors du même dépôt, sur les mésas M1, la première portion comporte moins d'indium à cause de la portion supérieure 24 à base d'AIGaN, et sur les mésas M3, la première portion comporte davantage d'indium grâce à la portion inférieure 22 porosifiée et à l'absence de la portion supérieure 24 d'AlGaN non porosifié. Ensuite, on réalise la zone active à puits quantiques, une deuxième portion à base d'InGaN dopé p. Une portion intercalaire de blocage d'électrons en GaN ou AIGaN peut être prévue entre la zone active et la deuxième portion dopée p.

Ainsi, le procédé de fabrication permet de réaliser de manière native des diodes D1, D2, D3 qui émettront à des longueurs d'onde différentes, ici dans les trois couleurs RGB. Ceci est possible par le fait que les mésas M1, M2, M3 présentent des déformabilités différentes d1, d2, d3. Aussi, l'incorporation d'indium dans les diodes, et en particulier dans les premières portions dopées n puis dans les puits quantiques des zones actives, dépend en effet de la déformabilité des mésas et du paramètre de maille effectif. Plus le paramètre de maille effectif de la portion de reprise d'épitaxie est important (après réalisation des diodes), plus la longueur d'onde principale de la diode correspondante sera grande. Le procédé de fabrication du substrat de croissance 20 met ainsi en jeu une étape de gravure photoélectrochimique, et au moins une étape de porosification électrochimique. Il n'a donc pas été besoin d'effectuer, comme dans l'art antérieur mentionné plus haut, des étapes d'implantation ionique localisée de dopants pour obtenir les différents types de mésas.

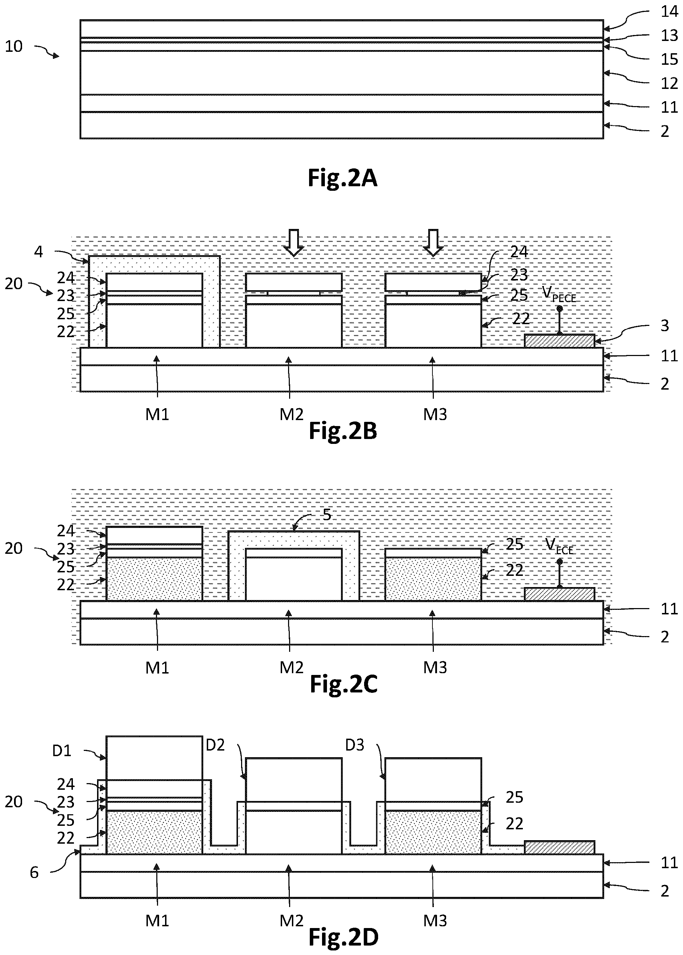

Les figures 2A à 2D illustrent des étapes d'un procédé de fabrication d'un substrat de croissance 20, puis d'une matrice de diodes D1, D2, D3, selon une variante du premier mode de réalisation, où l'empilement cristallin 10 comporte une couche intercalaire de reprise d'épitaxie 15 de faible épaisseur destinée à ne pas être porosifiée.

En référence à la fig.2A, on réalise un empilement cristallin 10 similaire à celui de la fig.1A, qui s'en distingue en ce qu'il comporte une couche intercalaire de reprise d'épitaxie 15, située entre et au contact de la couche inférieure 12 et de la couche intercalaire de séparation 13. Cette couche intercalaire de reprise d'épitaxie 15 est destinée à former les portions de reprise d'épitaxie 25 des mésas M2 et M3 après la suppression des portions supérieures 24 à base d'AlGaN et des portions intercalaires 23 à base d'InGaN. Elle peut être réalisée à base de GaN, par exemple en GaN ou en InGaN (avec une proportion d'indium faible, inférieure à celle de la couche intercalaire pour ne pas être gravée lors de l'étape de gravure photoélectrochimique). Elle est non intentionnellement dopée, ou faiblement dopée pour ne pas être porosifiée lors de l'étape de porosification électrochimique (niveau de dopage inférieur à celui de la couche inférieure 12). Son épaisseur est faible, par exemple de l'ordre de 10nm, pour ne pas impacter la déformabilité des mésas M1 et M3.

En référence à la fig.2B, on effectue la gravure électrochimique photo-assistée de la portion intercalaire 23 d'au moins les mésas M3 et non pas des mésas M1, et ici également des mésas M2. Cette étape est identique à celle décrite précédemment en lien avec la fig.1C. A la suite de cette étape, les faces supérieures des mésas M2 et M3 sont celles des portions de reprise d'épitaxie 25.

En référence à la fig.2C, on effectue la porosification électrochimique des portions inférieures 22 des seules mésas M1 et M3 et non pas des mésas M2. Cette étape est identique à celle décrite précédemment en lien avec la fig.1E. Du fait de la composition du matériau des portions de reprise d'épitaxie 25 des mésas M1 et M3 en termes de proportion d'indium et du niveau de dopage, ces portions ne sont pas porosifiées (comme la portion supérieure 24 des mésas M1, et à la différence des portions inférieures 22 des mésas M1 et M3).

En référence à la fig.2D, on réalise les diodes D1, D2, D3. Cette étape est similaire à celles décrites précédemment en lien avec les fig.1F et 1H. Notons qu'il n'est pas ici nécessaire de déposer une portion fine d'obturation des pores sur la face supérieure des mésas M3, dans la mesure où elle est formée ici de la portion de reprise d'épitaxie 25 (non porosifiée) et non pas de la portion inférieure 22 porosifiée.

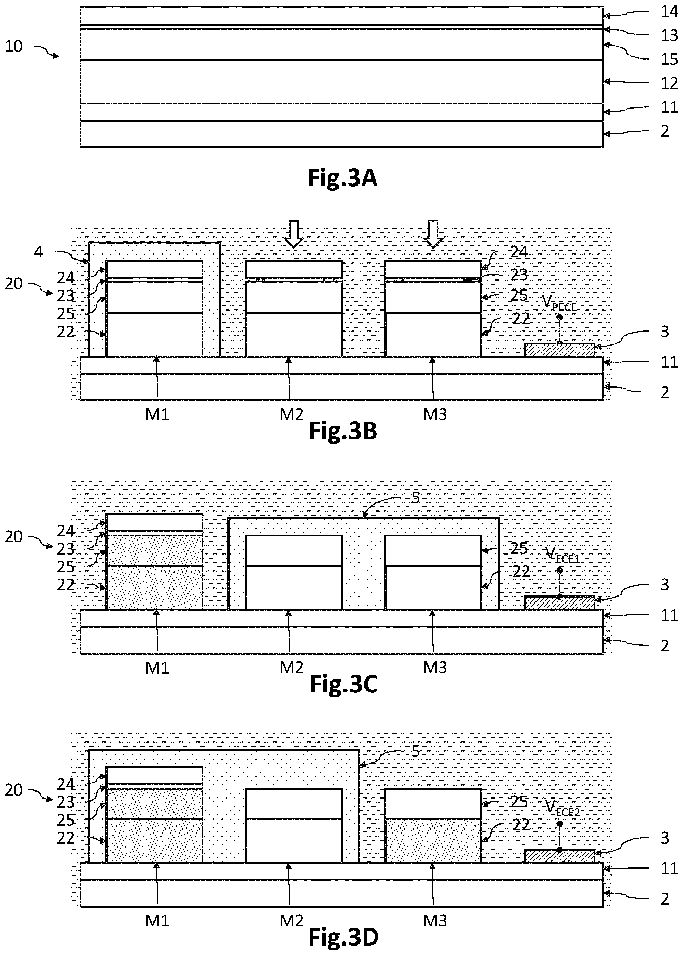

Les figures 3A à 3E illustrent des étapes d'un procédé de fabrication d'un substrat de croissance 20, puis d'une matrice de diodes D1, D2, D3, selon une autre variante du premier mode de réalisation, où l'empilement cristallin 10 comporte une couche de reprise d'épitaxie 15 destinée à être porosifiée, celle-ci présentant une épaisseur plus importante que celle décrite en lien avec les fig.2A-2D.

En référence à la fig.3A, on réalise un empilement cristallin 10 similaire à celui de la fig.2A, qui s'en distingue en ce que la couche intercalaire de reprise d'épitaxie 15, située entre et au contact de la couche inférieure 12 et de la couche intercalaire de séparation 13, est destinée à être porosifiée, et peut donc présenter une épaisseur supérieure à celle de la fig.2A. Comme dans la fig.2A, elle peut être réalisée à base de GaN, de préférence en InGaN avec une proportion d'indium faible, inférieure à celle de la couche intercalaire 13 pour ne pas être gravée lors de l'étape de gravure photoélectrochimique mais suffisante pour être porosifiée lors de l'étape de la fig.3C. Elle est dopée de telle sorte qu'elle n'est pas porosifiée lors de l'étape de porosification électrochimique de la fig.3D (inférieure à celle de la couche inférieure 12). Son épaisseur est plus importante que celle de la fig.2A, par exemple de l'ordre de plusieurs centaines de nanomètres. Dans cet exemple, elle est réalisée en InGaN avec une proportion d'indium de l'ordre de 5 à 8%, dopé de type n avec un niveau de dopage compris entre 10¹⁷ et 5×10¹⁸ cm⁻³, et d'une épaisseur égale à 200nm environ.

En référence à la fig.3B, on effectue la gravure électrochimique photo-assistée de la portion intercalaire 23 d'au moins les mésas M3, et ici également des mésas M2, et non pas des mésas M1. Cette étape est identique à celle de la fig.2B. A la suite de cette étape, les faces supérieures des mésas M2 et M3 sont celles des portions de reprise d'épitaxie 25.

En référence à la fig.3C, on effectue une première porosification électrochimique (non photo-assistée) de la portion inférieure 22 et de la portion de reprise d'épitaxie 25 des seules mésas M1. La portion inférieure 22 des mésas M3 sera porosifiée lors d'une autre étape de porosification électrochimique. Evidemment, les deux étapes de porosification peuvent être inversées. La couche d'encapsulation 5 recouvre donc les mésas M2 et M3. Le substrat de croissance 20 est plongé dans l'électrolyte liquide, et la tension V_{ECE1} est appliquée (16V environ). Aussi, la portion inférieure 22 et la portion de reprise d'épitaxie 25 des mésas M1 sont porosifiées, et non pas la portion supérieure 24 à base d'AIGaN.

En référence à la fig.3D, on effectue ensuite une deuxième porosification électrochimique (non photo-assistée) de la portion inférieure 22 uniquement des seules mésas M3. Ici, la couche d'encapsulation 5 recouvre les mésas M1 et M3. Une tension V_{ECE2} est appliquée (15V environ) dont la valeur est inférieure à V_{ECE1} pour ne porosifier que la portion inférieure 22 et non pas la portion de reprise d'épitaxie 25 des mésas M3. A la suite de ces deux étapes de porosification électrochimique, la face supérieure des mésas M1 est formée par la portion supérieure 24 en AlGaN non porosifié, et celles des mésas M2 et M3 sont formées par les portions de reprise d'épitaxie 25 non porosifiées.

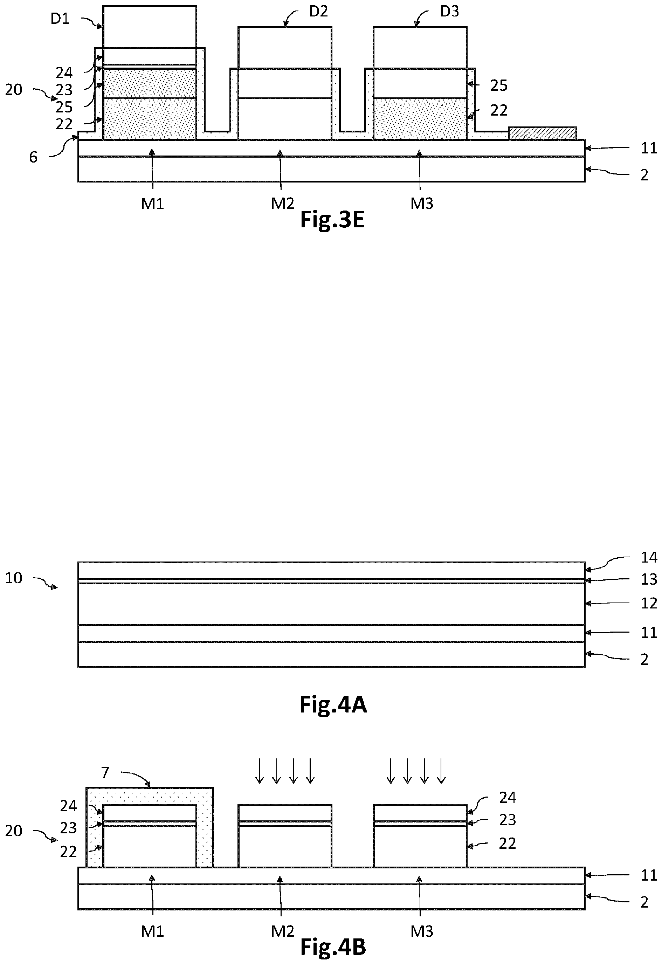

En référence à la fig.3E, on réalise les diodes D1, D2, D3. Dans la mesure où la face supérieure de l'une ou l'autre des mésas n'est pas formée par une portion porosifiée, il n'est pas nécessaire de déposer une couche fine d'obturation des pores. La réalisation des diodes D1, D2, D3 est effectuée comme décrit précédemment en lien avec la fig.2D.

Les figures 4A à 4F illustrent des étapes d'un procédé de fabrication d'un substrat de croissance 20, puis d'une matrice de diodes D1, D2, D3, selon un deuxième mode de réalisation où l'étape de gravure des portions supérieures 24 à base d'AlGaN est effectuée par gravure sèche. Dans cet exemple, l'empilement cristallin 10 est similaire à celui de la fig.1A, mais il pourrait également s'agir de celui de la fig.2A (avec une couche de reprise d'épitaxie 15 destinée à ne pas être porosifiée), comme de celui de la fig.3A (avec une couche de reprise d'épitaxie 15 destinée à être porosifiée).

En référence à la fig.4A, on réalise un empilement cristallin 10 reposant sur le substrat support 2. Il est ici similaire à celui de la fig.1A, et s'en distingue essentiellement en ce que la couche intercalaire de séparation 13 assure une fonction d'arrêt de gravure lors de l'étape de suppression des portions supérieures 24 d'au moins les mésas M3 (et ici également des mésas M2). Elle est réalisée à base d'InGaN avec une proportion d'indium suffisante pour assurer une sélectivité de gravure à l'interface AIGaN/InGaN.

En référence à la fig.4B, on réalise ensuite les mésas M1, M2 et M3 lors d'une première étape de gravure sèche, par exemple par gravure RIE avec un premier agent de gravure. Ici, l'agent de gravure est choisi pour être en mesure de graver localement la couche supérieure 14 à base d'AIGaN, puis la couche intercalaire 13 à base d'InGaN, et enfin la couche inférieure 12 à base de GaN. Le masque de gravure peut être disposé ici de manière à protéger le haut des mésas.

On effectue ensuite une deuxième étape de gravure sèche, par exemple par gravure RIE avec un deuxième agent de gravure. Un masque de gravure 7 (masque dur) est déposé pour recouvrir les mésas M1 et laisser libre la face supérieure d'au moins les mésas M3, et ici également celle des mésas M2. Il peut également recouvrir la face libre de la couche tampon conductrice 11. Ici, le deuxième agent de gravure est choisi pour être en mesure de graver localement les portions supérieures 24 à base d'AIGaN des mésas M2 et M3, et s'arrêter sur les portions intercalaires 23. Ensuite, le masque dur 7 est retiré. A la suite de cette étape, la face supérieure des mésas M1 est formée par la portion supérieure 24 à base d'AlGaN non porosifié, et celles des mésas M2 et M3 sont formées par la portion intercalaire 23 encore présente (qui peut être gravée sur une partie de son épaisseur, en fonction des conditions opératoires de la gravure sèche).

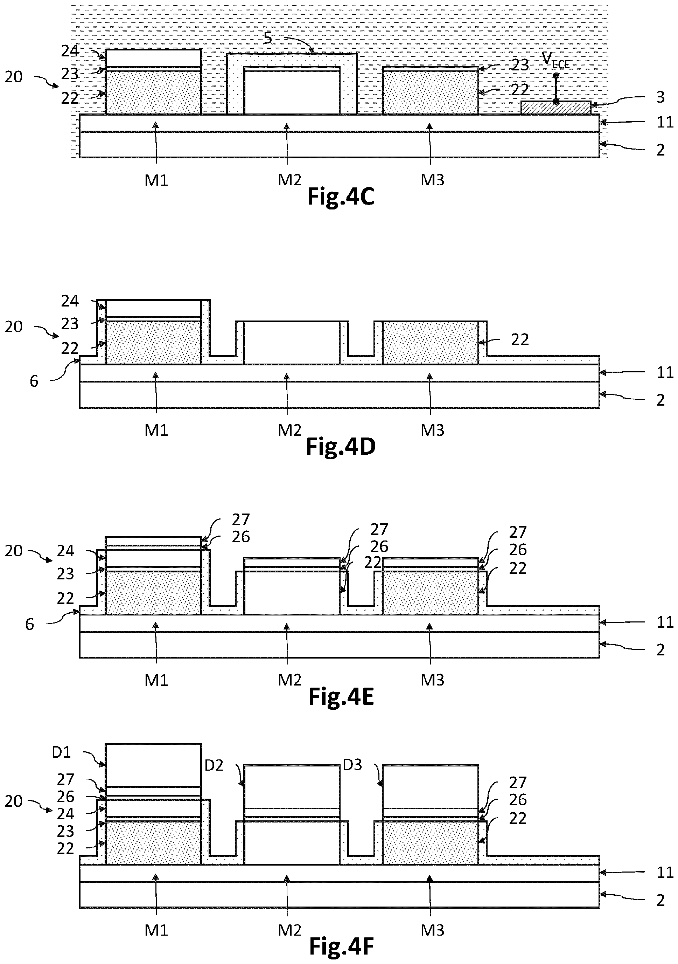

En référence à la fig.4C, on effectue une porosification électrochimique des portions inférieures 22 des seules mésas M1 et M3, et non pas des mésas M2. Cette étape est identique à celle de la fig.1E. Au préalable, on réalise l'électrode 3 sur et au contact de la couche tampon conductrice 11. Puis, on réalise la couche d'encapsulation 5 qui recouvre les seules mésas M2. On plonge le substrat de croissance 20 dans l'électrolyte liquide et on applique la tension électrique V_{ECE}. Les portions inférieures 22 des mésas M1 et M3 sont porosifiées, et non pas la portion supérieure 24 à base d'AIGaN des mésas M1. La couche d'encapsulation 5 est ensuite retirée.

En référence à la fig.4D, on dépose le masque de croissance 6 sur la couche tampon conductrice 11 et sur les flancs des mésas M1, M2, M3, laissant libre une surface de la face supérieure des mésas M1, M2 et M3. On peut également réaliser un recuit de nettoyage de la face supérieure des mésas, par exemple sous ammoniac et à haute température. Ce recuit peut ici supprimer par sublimation les portions d'arrêt de gravure 23 des mésas M2 et M3 qui peuvent présenter des défauts de surface liés à la gravure sèche. A la suite de cette étape, la face supérieure des mésas M1 est formée par la portion supérieure 24 non porosifiée, celle des mésas M2 est formée par la portion inférieure 22 non porosifiée, et celle des mésas M3 est formée par la portion inférieure 22 porosifiée.

En référence à la fig.4E, on dépose une fine couche d'obturation 26 à base de GaN sur les surfaces supérieures des mésas, et en particulier sur celle des mésas M3, de manière à obturer les pores de la portion inférieure 22 porosifiée qui débouchent sur la face supérieure. On réalise ensuite les portions de reprise d'épitaxie 27 sur les mésas M1, M2, M3, et en particulier sur les mésas M3.

En référence à la fig.4F, on réalise les diodes D1, D2, D3 à partir du substrat de croissance 20, de manière simultanée, par reprise d'épitaxie à partir des mésas M1, M2, M3, comme décrit en lien avec la fig.1H.

Des modes de réalisation particuliers viennent d'être décrits. Différentes variantes et modifications apparaîtront à l'homme du métier.

Ainsi, comme décrit précédemment, la portion supérieure 24 des mésas M2 peut être gardée, comme pour les mésas M1. Par ailleurs, la ou les étapes de porosification électrochimique non photo-assistée peuvent être réalisées avant l'étape de suppression de la portion supérieure 24 d'au moins la mésa M3. Enfin, les portions de reprise d'épitaxie 25, 27 peuvent être réalisées avant ou pendant l'étape de réalisation des diodes. Lorsqu'elles sont réalisées avant celle des diodes, elles peuvent être porosifiées, auquel cas elles présentent une épaisseur faible, ou elles peuvent ne pas être porosifiées, auquel cas elles peuvent présenter une épaisseur plus importante.

## Revendications

1. Procédé de fabrication d'un substrat de croissance (20) adapté à la réalisation par épitaxie d'une matrice de diodes (D1, D2, D3) à base d'InGaN, comportant les étapes suivantes :
∘ réalisation d'un empilement cristallin (10) à base de GaN, comportant, à partir d'une couche tampon conductrice (11) réalisée à base de GaN dopé :
• une couche inférieure (12) à base de GaN dopé ; puis
• une couche intercalaire de séparation (13), à base d'InGaN ; puis
• une couche supérieure (14) à base d'AIGaN ;
∘ réalisation de mésas de trois catégories M1, M2, M3, par gravure localisée de l'empilement cristallin (10), chaque mésa étant alors formée d'un empilement d'une portion inférieure (22), d'une portion intercalaire de séparation (23), et d'une portion supérieure (24), issues respectivement de la couche inférieure (12), de la couche intercalaire de séparation (13) et de la couche supérieure (14) ;
∘ suppression, par gravure, de la portion supérieure (24) d'au moins les mésas M3, la portion supérieure (24) des mésas M1 étant préservées ; puis
∘ porosification électrochimique non photo-assistée des portions inférieures (22) des seules mésas M1 et M3, la portion inférieure (22) des mésas M2 étant non porosifiée.

2. Procédé de fabrication selon la revendication 1, dans lequel l'étape de suppression est réalisée par gravure photoélectrochimique de la portion intercalaire de séparation (23) d'au moins les mésas M3, les mésas M1 étant recouvertes par une couche d'encapsulation (4).

3. Procédé de fabrication selon la revendication 1, dans lequel l'étape de suppression est réalisée par gravure sèche de la portion supérieure (24) d'au moins les mésas M3, avec arrêt de gravure sur la portion intercalaire de séparation (23), les mésas M1 étant recouvertes par un masque de gravure (7).

4. Procédé de fabrication selon l'une quelconque des revendications 1 à 3, dans lequel, à la suite de l'étape de réalisation des mésas, la portion intercalaire de séparation (23) est, dans chaque mésa, sur et au contact de la portion inférieure (22), le procédé comportant une étape de réalisation de portions de reprise d'épitaxie (27) réalisée à base d'InGaN, effectuée après l'étape de porosification électrochimique, reposant sur la portion supérieure (24) dans les mésas M1, et reposant sur la portion inférieure (22) dans les mésas M3.

5. Procédé de fabrication selon la revendication 4, comportant, à la suite des étapes de suppression et de porosification et avant l'étape de réalisation de la portion de reprise d'épitaxie (27), une étape de réalisation d'une portion d'obturation (26) déposée au moins sur et au contact de la portion inférieure (22) des mesas M3 alors porosifiée.

6. Procédé de fabrication selon l'une quelconque des revendications 1 à 3, dans lequel, lors de l'étape de réalisation de l'empilement cristallin (10), une couche de reprise d'épitaxie (15) est située sur et au contact de la couche inférieure (12), de sorte que, à la suite des étapes de suppression et de porosification, les mésas M3 présentent une face supérieure formée par une portion de reprise d'épitaxie (25) issue de la couche de reprise d'épitaxie (15).

7. Procédé de fabrication d'une matrice de diodes de catégories D1, D2, D3 à partir d'un substrat de croissance (20), comportant les étapes suivantes :
∘ fabrication du substrat de croissance (20) par le procédé selon l'une quelconque des revendications précédentes ; puis
∘ dépôt d'un masque de croissance (6), laissant libre une surface supérieure des mésas M1, M2, M3 ; puis
∘ réalisation de la matrice de diodes D1, D2, D3, respectivement à partir des mésas M1, M2, M3.

8. Substrat de croissance (20) adapté à la réalisation par épitaxie d'une matrice de diodes à base d'InGaN, comportant :
∘ une couche tampon conductrice (11), réalisée à base de GaN dopé ;
∘ des mésas de trois catégories M1, M2, M3, reposant sur la couche tampon conductrice (11), comportant chacune une portion inférieure (22) réalisée à base de GaN dopé, et
• les mésas M1 comportant en outre une portion intercalaire de séparation (23) non poreuse et réalisée à base d'InGaN, reposant sur la portion inférieure (22) poreuse ; puis une portion supérieure (24) non poreuse et réalisée à base d'AlGaN ;
• les mésas M2 étant formés de la portion inférieure (22) non poreuse ;
• les mésas M3 étant formés de la portion inférieure (22) poreuse, et ne comportant pas de portion supérieure (24) non poreuse réalisée à base d'AIGaN reposant sur la portion inférieure (22).

9. Substrat de croissance selon la revendication 8, dans lequel chaque mésa M1, M2, M3 comporte une portion de reprise d'épitaxie (27) non poreuse réalisée à base d'InGaN dopé, reposant, dans les mésas M1, sur la portion supérieure (24), et, dans les mésas M3, sur la portion inférieure (22).

10. Substrat de croissance selon la revendication 9, dans lequel chaque mésa M1, M2, M3 comporte une portion d'obturation (26) non poreuse réalisée à base de GaN, située, dans les mésas M1, entre et au contact de la portion supérieure (24) et de la portion de reprise d'épitaxie (27), et dans les mésas M3, entre et au contact de la portion inférieure (22) et de la portion de reprise d'épitaxie (27).

11. Substrat de croissance selon la revendication 8, dans lequel chaque mésa M1, M2, M3 comporte une portion intercalaire de reprise d'épitaxie (25) réalisée à base d'InGaN et située, dans les mésas M1, entre la portion inférieure (22) et la portion intercalaire de séparation (23), dans les mésas M3, sur la portion inférieure (22).

12. Substrat de croissance selon la revendication 11, dans lequel la portion intercalaire de reprise d'épitaxie (25) de chaque mésa M1, M2, M3 est non poreuse.

13. Substrat de croissance selon la revendication 11, dans lequel la portion intercalaire de reprise d'épitaxie (25) est poreuse dans les mésas M1, et non poreuse dans les mésas M2 et M3.
